# EUROPEAN PATENT APPLICATION

(11) **EP 2 369 104 A1**
(43) Date of publication of application: **28.09.2011**
(21) Application number: 09827114.1
(22) Date of filing: 20.11.2009
(51) Int. Cl.: E05B 65/52, E05B 73/00, E05B 47/06, E05B 49/02

(54) **ELECTRIC LOCKING AND SEALING DEVICE, BOX WITH ELECTRIC LOCKING AND SEALING DEVICE AND CONTROL SYSTEM**

(30) Priority: 20.11.2008 CN 200810177929; 22.01.2009 CN 200910003979
(71) Applicant: Hubei Shengjia Wiring Co., Ltd., Wuhan, Hubei 430012 (CN); Wan, Jiasheng, Hubei 430012 (CN)
(72) Inventor: WAN, Jiasheng, Hubei 430023 (CN)
(74) Representative: Hryszkiewicz, Danuta
(86) International application number: PCT/CN2009/001286
(87) International publication number: WO 2010/057365

(57) **Abstract**

An electric locking and sealing device includes a shell (**11, 16**), a lock tongue (**12**), an action unit (**13**) for pushing out or taking back the lock tongue (**12**), a main control unit (a**3**) and a connection element (**3**). Thereinto, the action unit (**13**) is provided in the shell (**11, 16**) and fixedly connected with the lock tongue (**12**) for pushing out or taking back the lock tongue (**12**) from the shell (**11, 16**); the main control unit (a**3**) is connected with the action unit (**13**) for automatically controlling the action of the action unit (**13**) after receiving an external control signal; and the connection element (**3**) has an aperture (**31**) in middle part for the lock tongue (**12**) extending through.

## Description

The invention relates to an electronic locking and sealing technique, and more particularly to a device that fixes a connecting part from inside whereby preventing it from being illegally opened, and application of disposing the electronic locking and sealing device on a case or on a box whereby preventing the case or the box from being illegally opened.

Normally, combination of two independent structures is facilitated via a connecting part whereby forming a complete body, for example, connection via screw thread or a lock. However, connection via the screw thread or the lock has many disadvantages: taking a case for example, it normally comprises a cover and a bottom case, and the cover and the bottom case are connected via a screw whereby forming the case, or via a built-in lock whereby forming a complete body, however, it is possible for someone to open a binding site of the connecting part, if he pulls out the screw or breaks the lock without permission, the two independent structures are separated, namely the case is opened, which causes facilities in the case or a box are easy to be destroyed.

The above-mentioned problems are very obvious in conventional power systems, for a multi-epitope electricity meter box with multiple meters, or a single electricity meter box, since the electric meter is a base for managing power consumption of uses, and enables a power management department to charge the users, some users illegally open the case, and use different methods to modify or corrupt power management devices in the case, which brings great loss for the power management department. Therefore, some developers set lead seal on the screw packaging the case. On one hand, illegal users still can remove the lead seal via destructive methods whereby opening the case, on the other hand, it is very inconvenient for stuffs of the power management department to open the case.

In view of this, the inventor created a new anti-stealing method in China Patent No. 200710101440.6 named "electronic seal", comprising a seal-detection device, a power supply circuit, a control circuit, and an executing circuit. The power supply circuit supplies operation voltage for the control circuit, the executing circuit, and a detection component of the seal-detection device. As a control part in the seal-detection device moves with respect to the detection device, namely the control part between the cover and the bottom case is loosen and/or corrupted, the control circuit detects an electric signal from the detection device, and simultaneously transmits a control signal to the executing circuit and a warning circuit. An executing part of the executing circuit switches off the power supply, a water circuit, and a gas circuit, and the warning circuit sends a warning signal, so that as people touches the seal without permission, instant waning and/or operation is performed to stop illegal activities, and the circuit is self-locked whereby preventing loss. Although the invention prevents power loss, it only provides a comparatively lagging solution, namely it only operates as the control part is loosen and/or destructed. For the power management department, it still requires restoring normal power supply, which is very inconvenient. Therefore, new problems, namely how to effectively prevent illegal users from opening the case, and thus making it is very hard for users to open the case, and very easy for the power management department to do this, occur.

In view of the above-mentioned disadvantages with the prior art, and urgent and realistic requirement, the inventor makes the invention after long-term research and practice.

It is an objective of the invention to provide an electronic locking and sealing device and a case with the electronic locking and sealing device that are capable of addressing the above-mentioned problems.

To achieve the above objectives, provided is an electronic locking and sealing device, comprising a housing, it further comprises a lock tongue, an operating unit disposed in the housing and fixedly connected to the lock tongue, and operating to push out or to take back the locking tongue from or in the housing, a main control unit connected to the operating unit, and operating to receive an external control instruction whereby automatically controlling the operating unit, and a connecting part having a hole disposed at the center thereof and corresponding to the lock tongue.

Also provided is a case with an electronic locking and sealing device, comprising a bottom case, and a cover having an insertion hole, it further comprises an electronic locking and sealing device disposed in the bottom case and comprising a housing, a lock tongue, an operating unit disposed in the housing and fixedly connected to the lock tongue, and operating to push out or to take back the locking tongue from or to the housing, a main control unit connected to the operating unit, and operating to receive an external control instruction whereby automatically controlling the operating unit, and a connecting part inserted into the insertion hole, the top of the connecting part being fixed on the insertion hole, and a hole being disposed at the center of the connecting part, and corresponding to the lock tongue.

To prevent the electronic locking and sealing device from being dismounted from the case, the housing is connected to the bottom case from the inside thereof via a screw.

Finally provided is a control system for the electronic locking and sealing device and the case with the electronic locking and sealing device, comprising: a power supply operating to supply power, a control unit operating to receive a push-out/take-back control instruction, and to output a trigger signal driving a lock tongue to operate, a main control unit operating to receive an external control instruction, and to output the push-out/take-back control instruction to the control unit, and an external control unit operating to output the external control instruction.

Advantages of the invention over the prior art comprise: it effectively implements sealing of a binding site between two independent connecting parts, and thus preventing external tools from directly contacting with the binding site of the connecting parts; if the invention is applied to an electricity meter case or an electricity meter box, it can effectively prevents power from being stolen by opening the box or the case; it features high safety and makes it possible for a power management department to control and implement effective management; the invention is also suitable for solving electricity stealing problems occurred at binding sites of connecting structure.

The auxiliary control system effectively prevents a problem that a single electronic locking and sealing system cannot be normally controlled as failure occurs.

The protection circuit effectively prevents reverse connection of the power supply or high-voltage corruption, which improves safety of the control system in use.

FIG. **1** is a schematic view of an electronic locking and sealing device of a first embodiment of the invention;

FIG. **2** is a schematic view of an electronic locking and sealing device of a second embodiment of the invention;

FIG. **3** is a schematic diagram of a main control unit of an electronic locking and sealing device of the invention;

FIG. **4** is a schematic diagram of a power supply of an electronic locking and sealing device of the invention;

FIG. **5** is a schematic diagram of a control part of an operating unit of an electronic locking and sealing device of a first embodiment of the invention;

FIG. **6** is a schematic diagram of a control part of an operating unit of an electronic locking and sealing device of a second embodiment of the invention;

FIG. **7** is an exploded view of a case with an electronic locking and sealing device of a first embodiment of the invention;

FIG. **8** is an exploded view of a case with an electronic locking and sealing device of a second embodiment of the invention;

FIG. **9** is an exploded view of a case (electricity meter case) with an electronic locking and sealing device of a third embodiment of the invention;

FIG. **10** is a side cross-sectional view of a case (electricity meter case) with an electronic locking and sealing device of a third embodiment of the invention;

FIG. **11** is an exploded view of a case (electricity meter case) with an electronic locking and sealing device of a fourth embodiment of the invention;

FIG. **12** is a side cross-sectional view of a case (electricity meter case) with an electronic locking and sealing device of a fourth embodiment of the invention;

FIG. **13** is a circuit diagram of an external control device of an electronic locking and sealing device of the invention;

FIG. **14** is a schematic view of an electronic locking and sealing device corresponding to a control system of the invention;

FIG. **15** is a block diagram of a control system of a first embodiment of the invention;

FIG. **16** is a block diagram of a control system of a second embodiment of the invention;

FIG. **17** is a circuit diagram of an auxiliary control unit and a control unit in a control system of the invention;

FIG. **18** is a circuit diagram of an auxiliary main control unit in a control system of the invention;

FIG. **19** is a circuit diagram of an auxiliary external control unit in a control system of the invention;

FIG. **20** is a schematic view of a protection circuit in a control system of the invention; and

FIG. **21** is a schematic view of a first input interface circuit of an external control unit in a control system of the invention.

The above-mentioned and additional features and advantages of the invention will be described in details in conjunction with accompanying drawings.

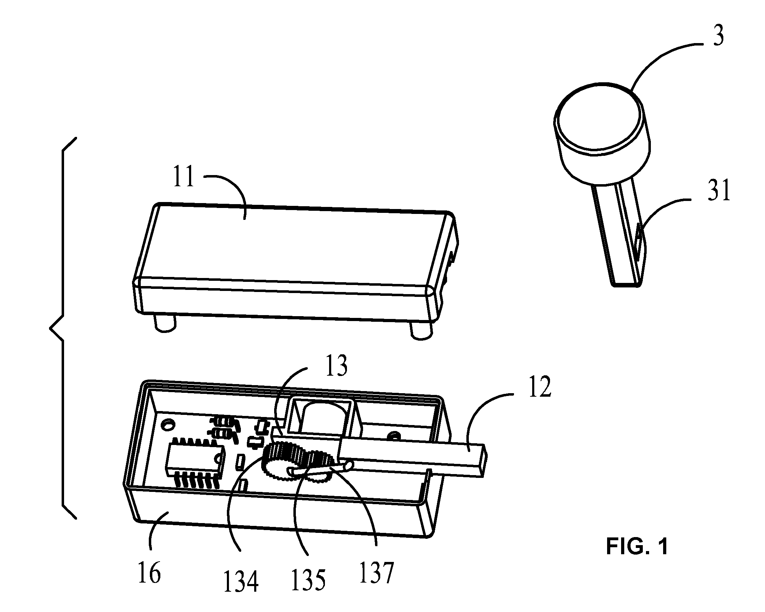

As shown in FIG. **1****,** a schematic view of an electronic locking and sealing device of a first embodiment of the invention is shown. The electronic locking and sealing device comprises: a housing comprising an upper housing **11** and a lower housing **16,** a lock tongue **12** being disposed in the housing, and the lock tongue **12** being capable of extending to the outside of the housing; an operating unit **13** disposed in the housing and fixedly connected to the lock tongue **12,** and operating to push out or to take back the locking tongue **12** from or to the housing. The operating unit **13** comprises: a power output mechanism, and an output end thereof is connected to the lock tongue **12.** The power output mechanism comprises a motor **135,** and a multiple-stage reduction part **134** (can be a multiple-stage gear reduction part) connected to an output shaft thereof, the multiple-stage gear reduction part is connected to the lock tongue **12** via a connecting shaft **137,** the motor **134** outputs rotating speed, and the multiple-stage gear reduction part **134** reduces speed and increases torque. Movement of the connecting shaft **137** is similar to connection between a piston and a rotating shaft of a vehicle, namely, rotation of an output stage gear is transformed into reciprocal movement of the lock tongue **12** along a line, and will not be described hereinafter;
a main control unit operating to receive a control instruction, the main control unit can be disposed on a main board in the housing, or outside of the housing (not shown). Normally, the control instruction is from an external device and implemented via wireless control or a RFID technique, and controls the lock tongue **12** to operate, which to certain extent, reduces direct human-induced effect on the housing, and thus the main control unit automatically controls operation of the operating unit **13;** and
a connecting part **3** having a hole **31** disposed at the center thereof and corresponding to the lock tongue **12.** As the lock tongue **12** extends from the housing, it is received in the hole **31.**

In fact, in this embodiment, the operating unit **13** can employ a gear and rack structure instead of the connecting shaft **137,** namely the output stage gear is combined with the lock tongue having a rack structure, and rotation of the motor **134** controls push-out or take-back of the lock tongue **12,** and the structure will not be described hereinafter.

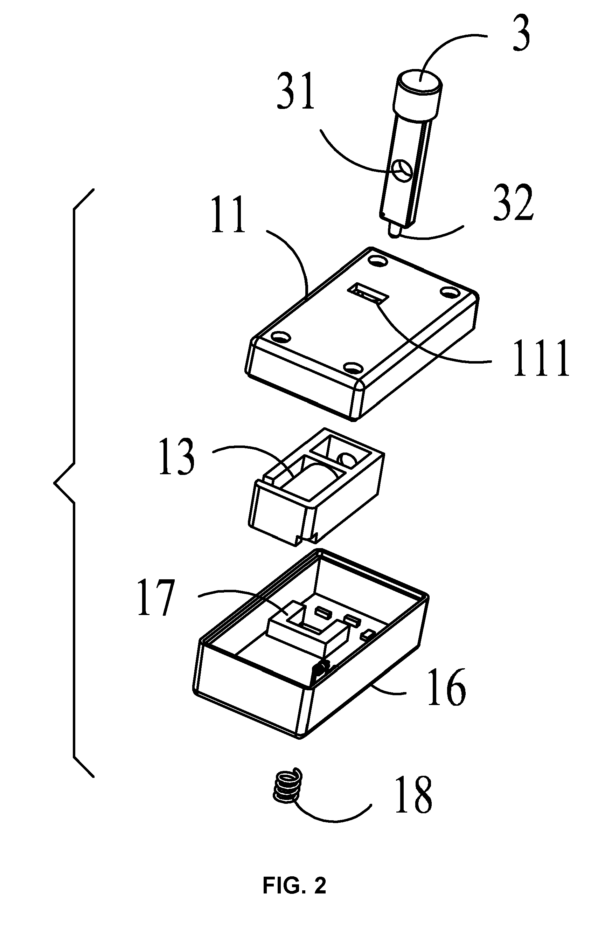

As shown in FIG. **2****,** a schematic view of an electronic locking and sealing device of a second embodiment of the invention is shown. Difference between the electronic locking and sealing device of the second embodiment of the invention and that of the first embodiment is that, an opening **111** is disposed on the upper housing **11,** the lock tongue **12** moves in the housing, the connecting part **3** extends into the opening **111** of the upper housing **11,** the operating unit **13** is disposed in the housing and fixedly connected to the lock tongue **12,** and operates to push out or to take back the locking tongue **12** from or to the housing, so that the lock tongue **12** is received in the opening **111** of the connecting part.

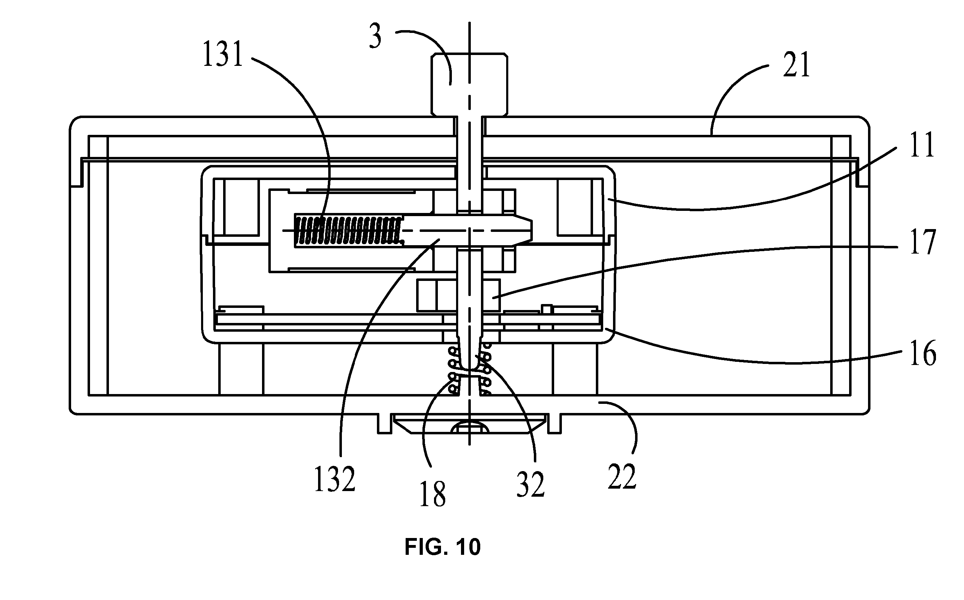

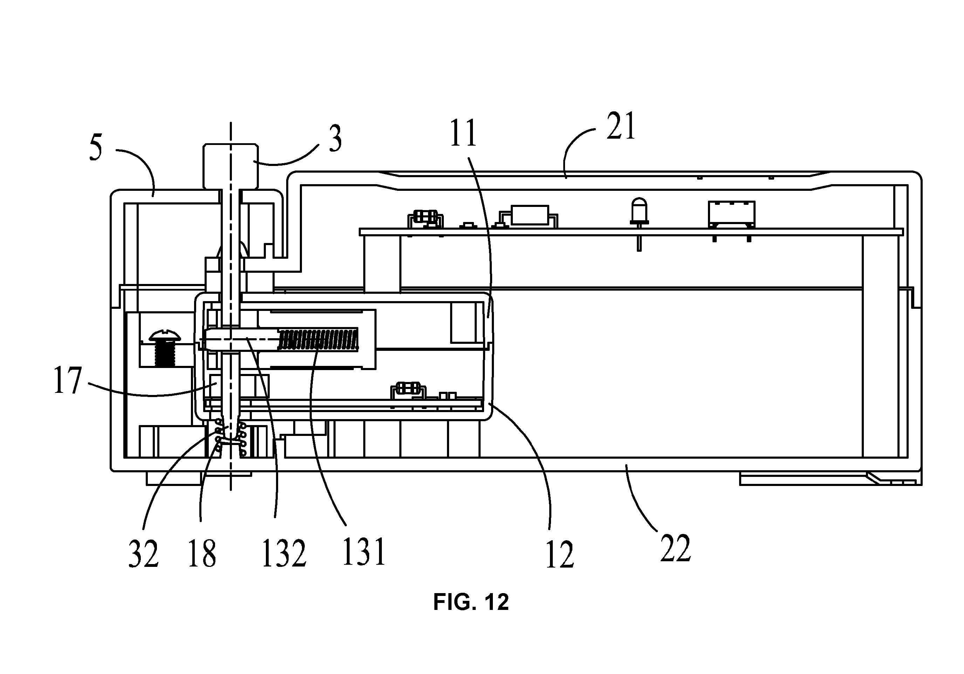

As shown in FIGS. **10** and **12****,** the operating unit **13** comprises a power output mechanism having an output end being connected to the lock tongue. The power output mechanism in this embodiment can be the same as that in the first embodiment, or employs an electromagnetic type comprising an electromagnetic operating part, comprising an armature **132,** an electromagnetic coil **131,** and a load bearing part. One end of the armature **132** is fixedly connected to the lock tongue **12,** and integrated in the load bearing part. A reset spring is fit on the armature **132.**

In addition, a self-test unit is added in comparison with the first embodiment. The self-test unit operates to detect whether the connecting part **3** is received in the opening **111** of the housing, and to trigger the lock tongue **12** to operate. The self-test unit comprises: a U-shaped groove **17,** the U-shaped groove **17** comprises a light receiving end, and a light emitting end, a light path being formed therebetween, and a control signal is generated during switching between closing and opening of said light path. Namely, as the connecting part **3** is received in the opening **111** of the upper housing and extends into the U-shaped groove **17,** the light path is obstructed, at this time, the main control unit obtains a control signal, the electromagnetic operating part operates, and the lock tongue **12** extends and is received in the opening **111** of the connecting part.

Alternatively, the self-test unit comprises a pressure sensor corresponding to the top of the connecting part. Namely, as the connecting part is received in the opening **111** of the upper housing, the top thereof presses the pressure sensor, the main control unit obtains a control signal, the electromagnetic operating part operates, and the lock tongue **12** extends and is received in the opening **111** of the connecting part.

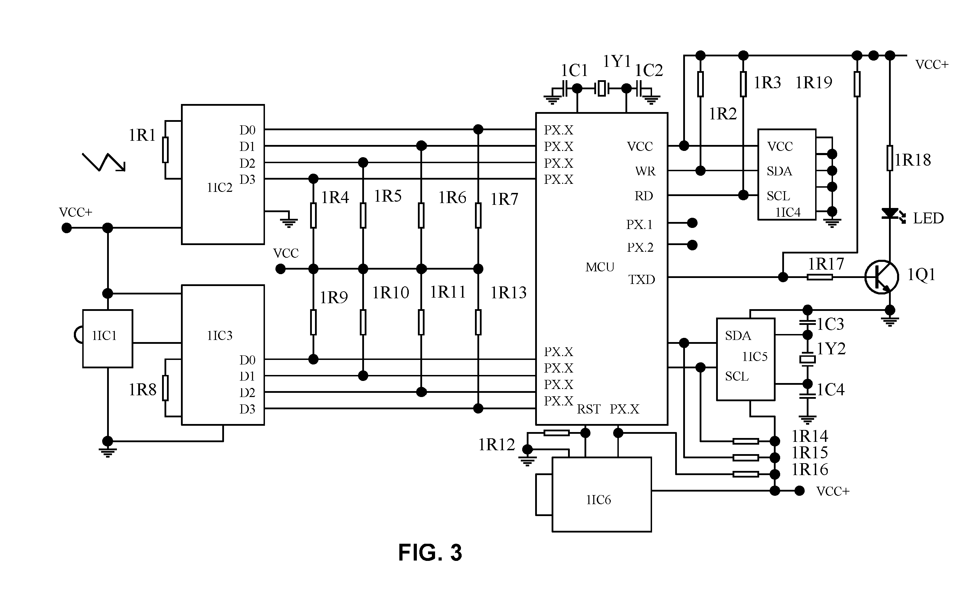

As shown in FIG. **3****,** a circuit diagram of a main control unit of an electronic locking and sealing device of the invention is shown. The main control unit comprises:
an instruction receiving sub-unit operating to receive a control instruction, the control instruction being provided from an external wireless device, which solves safety problem caused by mechanical contact-type control. There are three different methods to implement this: an infrared receiver 1 IC1 and a decoder circuit 1 IC3 are used, or only one radio receiver 1 IC2 is used.
Resistors 1 R8 and 1 R1 are used for starting oscillation. If the radio receiver 1 IC2 is used, an output signal is a decoded digital signal. To improve safety, the infrared receiver 1 IC1 and the radio receiver 1 IC2 are used to simultaneously receive the external control instruction, and to transmit the external control instruction to a corresponding instruction processing sub-unit; multiple pull-up resistors 1 R4-1 R13 are disposed between the infrared receiver 1 IC1 and the radio receiver 1 IC2, and the instruction processing sub-unit;
an instruction processing sub-unit being a microprocessor chip MCU and operating to process a control instruction, ports PX.1 and PX.2 of the microprocessor chip MCU output a push-out instruction signal, a take-back instruction signal, or a static instruction signal to a control part of the operating unit **13;**
a clock chip 1 IC5 connected to the microprocessor chip MCU, and operates to provide an external clock signal for operation of the microprocessor chip MCU.
The clock signal operates as an encryption/decryption factor. After the microprocessor chip MCU receives two types of decoded digital signal via the infrared receiver 1 IC1 and the radio receiver 1 IC2, the clock signal is operated as a random number, whereby verifying whether it is a legal command. The invention also comprises a watchdog chip 1 IC6;
a storage chip 1 IC4 connected to the microprocessor chip MCU and operating to store data, the data being operation time and frequency of the operating unit; and
a data transmission interface connected to the microprocessor chip MCU, and operating to transmit various events in the microprocessor chip MCU to an external receiving device. A circuit structure is that, an output end of the microprocessor chip MCU is connected to a base electrode of a triode 1Q1, a collecting electrode of the triode 1Q1 is connected to an infrared emitting diode LED, data are transmitted in a form of infrared signals, and other transmission types can be used.

The instruction receiving sub-unit can also be a RFID card reader circuit. An antenna in the RFID card transmits signals, a card reader in the RFID card reader circuit reads and recognizes the signals, and the microprocessor chip MCU transmits a start instruction after information authentication is completed.

Since each electronic device consumes power, power resource of the invention can use independent devices such as batteries, or city power according to different power utilization environments.

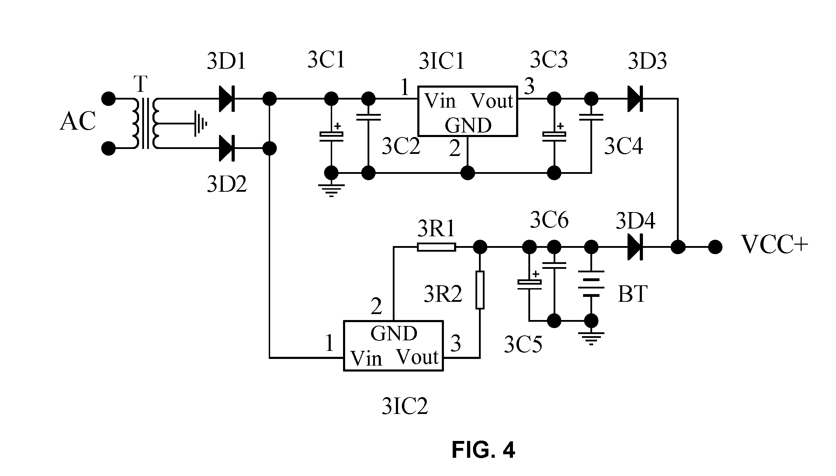

As shown in FIG. **4**, a schematic diagram of a power supply of an electronic locking and sealing device of the invention is shown. The power supply uses city power, and comprises a transformer reducing voltage of city power, rectifying via two diodes 3D1 and 3D2, and dividing the voltage into two parts. One part of voltage passes through a voltage stabilizing circuit 3IC1, and is output after being filtered via capacitors 3C1-3C4. The other part of voltage passes through a constant current circuit comprising a current constant chip 3IC2, and two resistors 3R2 and 3R1, and recharges a rechargeable battery BT after being filtered via capacitors 3C5-3C6. As power failure occurs, the rechargeable battery BT supplies power. To prevent counter current, two diodes 3D3 and 3D4 are disposed on both parts.

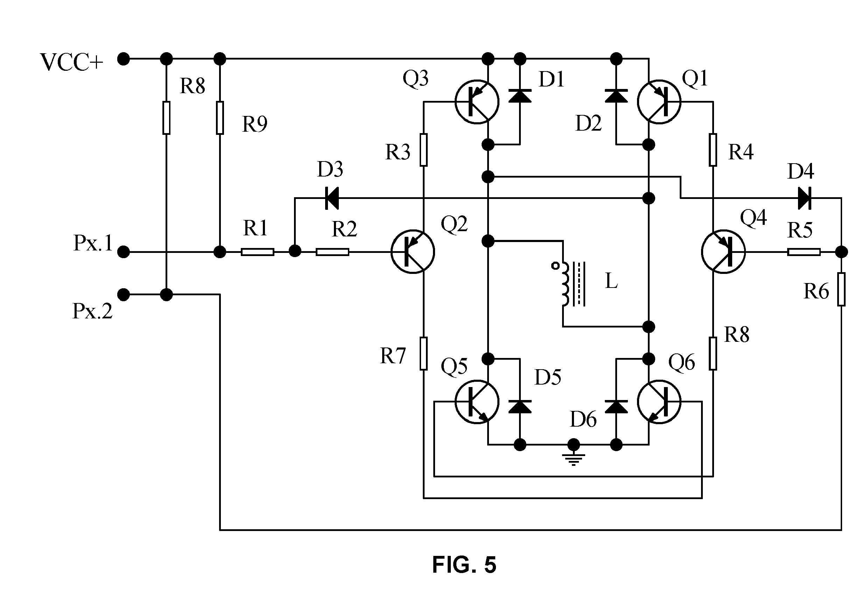

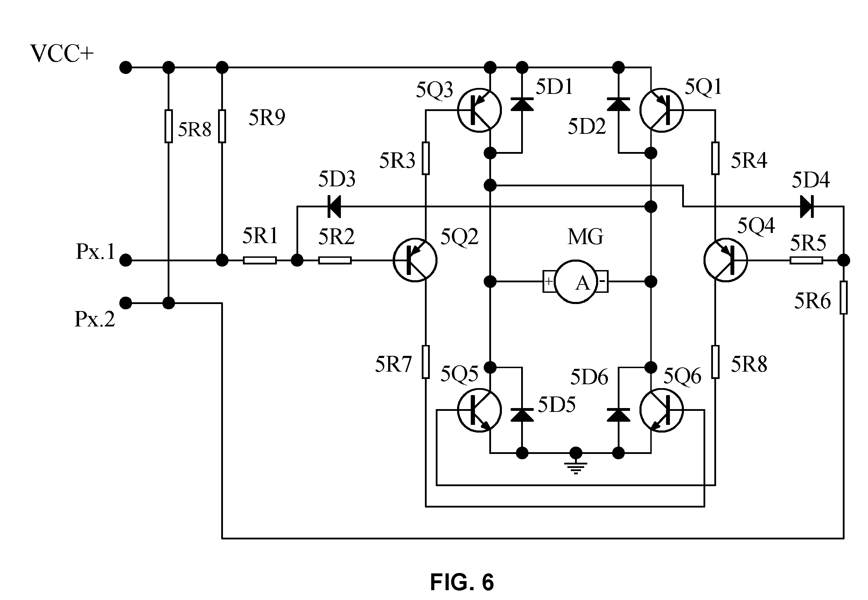

As shown in FIG. **5** and FIG. **6****,** schematic diagrams of a control part of an operating unit of an electronic locking and sealing device of a two embodiments of the invention are shown. An electromagnet used for the operating part has a self-holding function, and thus does not need a self-locking mechanism. PX.1 and PX.2 are output ends of the microprocessor chip MCU. As PX.1 is low level, and PX.2 is high level, triodes 5Q2, 5Q3 and 5Q6 are on, and triodes 5Q4, 5Q1 and 5Q5 are off, current flowing through the electromagnetic coil or the motor has a first direction, and thus forming a first movement direction for the lock tongue. As PX.1 is high level and PX.2 is high level, the triodes 5Q2, 5Q3, 5Q6, 5Q4, 5Q1 and 5Q5 are off, at this time no current flows through the electromagnetic coil or the motor, and thus the lock tongue stops moving. As PX.1 is high level and PX.2 is low level, the triodes 5Q2, 5Q3 and 5Q6 are off, and the triodes 5Q4, 5Q1 and 5Q5 are on, a direction of current flowing through the electromagnetic coil or the motor is opposite to the first direction, and the lock tongue moves in a reverse direction. As PX.1 and PX.2 are low level, no current flows through the electromagnetic coil or the motor, and thus the lock tongue stops moving.

Structure of the electronic locking and sealing device is described hereinbefore from a mechanical part to a circuit part, a case with the electronic locking and sealing device, namely application of the electronic locking and sealing device in warehousing and electricity anti-stealing, will be given hereinafter. The following content only describes application of a power meter case and an electricity meter case, and is based on an idea that a binding site of the connecting part of the electronic locking and sealing device that seals and locks the box or the case is disposed inside, and connecting holes of the connecting part cannot be reached, which reduces risks of being illegal opening.

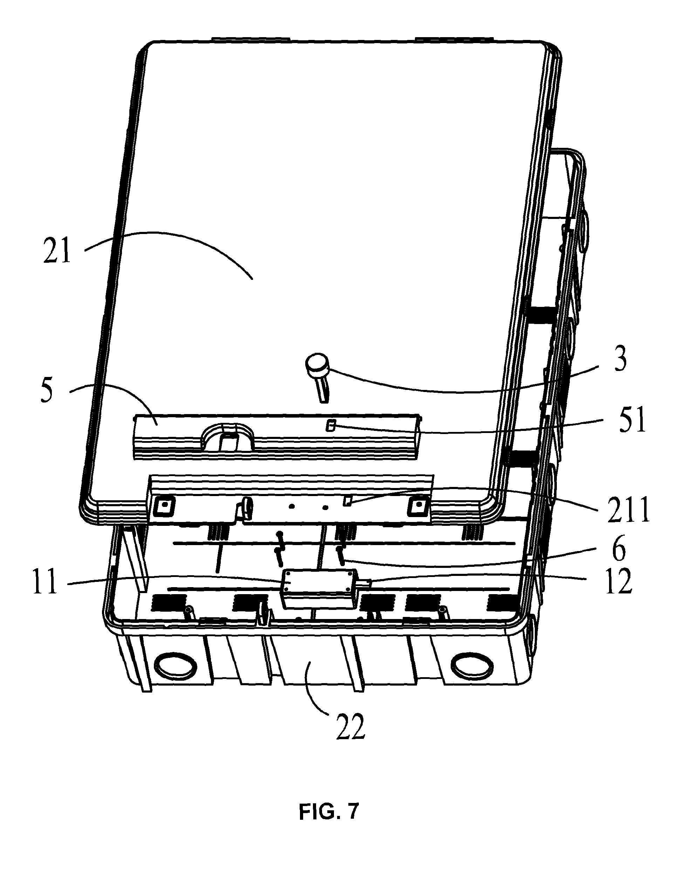

As shown in FIG. **7****,** an exploded view of a case with an electronic locking and sealing device of a first embodiment of the invention is shown. The case with an electronic locking and sealing device comprises a bottom case **22** and a cover **21.** The cover **21** has an insertion hole **211.** It further comprises: an electronic locking and sealing device disposed in the bottom case **22.** The electronic locking and sealing device corresponds to the embodiment in FIG. **1****,** and comprises a housing, comprising an upper housing **11** and a lower housing **16.** The housing is combined with the bottom case **22** from the inside of the case via a screw **6.** It further comprises a cap **5** covering the cover **21** after the bottom case **22** is combined with the cover **21.** A cap hole **51** is disposed on the cap, and the cap hole **51** corresponds to the insertion hole **211** of the cover **21.** The connecting part **3** is received in the case via the cap hole **51** on the cap, and the insertion hole **211** of the cover **21.** At this time, the lock tongue **12** extends from the housing and is received in the hole **31** of the connecting part via a RFID card or wireless control. The top of the connecting part **3** is fixed to the cap hole **51** (or on the insertion hole **211** of the cover **21** if no cap **5** is used), and the bottom thereof is blocked by the lock tongue **12,** which make it impossible to pull the connecting part **3** out from the hole, and thus implementing combination of the cover **21** with the bottom case **22.** The combination makes it difficult to open the case from outside, because it is impossible to touch the hole **31** of the connecting part.

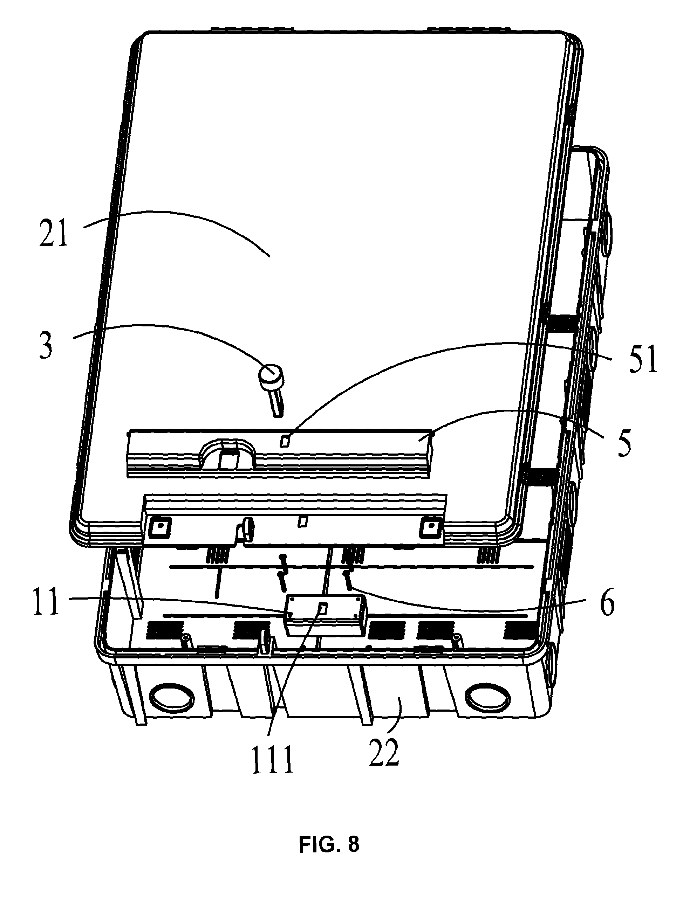

As shown in FIG. **8****,** an exploded view of a case with an electronic locking and sealing device of a second embodiment of the invention is shown. Difference between this embodiment and the first embodiment is that, this embodiment corresponds to the electronic locking and sealing device in FIG. **2****.** The lock tongue **12** is disposed in the housing, an opening **111** is disposed on the upper housing **11,** the connecting part **3** is received in the opening **111** of the upper housing in the case via the cap hole **51** on the cap **5,** and the insertion hole **211** of the cover **21.** At this time, the lock tongue **12** is received in the hole **31** of the connecting part via a RFID card or wireless control. The top of the connecting part **3** is fixed to the cap hole **51** (or on the insertion hole **211** of the cover **21** if no cap **5** is used), the connecting part **3** extends into the housing, and the bottom thereof is blocked by the lock tongue **12,** which make it impossible to pull the connecting part **3** out from the hole, and thus implementing combination of the cover **21** with the bottom case **22.** The combination makes it difficult to open the case from outside, because it is impossible to touch the hole **31** of the connecting part.

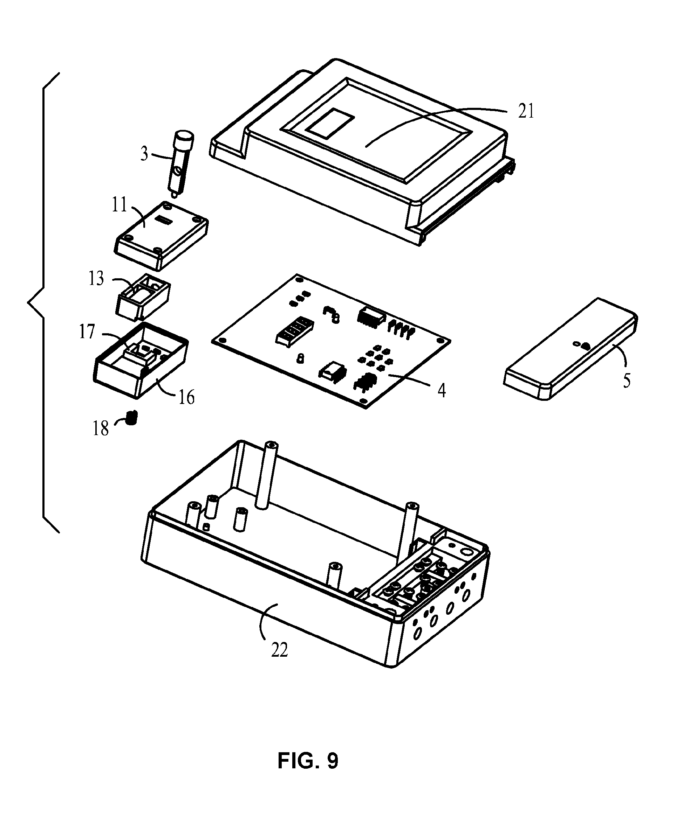

As shown in FIG. **9** and FIG. **10****,** an exploded view and a side cross-sectional view of a case (electricity meter case) with an electronic locking and sealing device of a third embodiment of the invention are respectively shown. In fact, the first embodiment and the second embodiment are applied to an electricity meter case, and this embodiment is applied to an electricity meter box. The electricity meter box with an electronic locking and sealing device comprises a bottom box **22,** and a box cover **21.** An insertion hole is disposed on the box cover **21** (not shown). It further comprises an electronic locking and sealing device disposed in the bottom box **22;** and the electronic locking and sealing device corresponds to the embodiment in FIG. **2****,** and comprises a housing. The housing comprises an upper housing **11,** and a lower housing **16.** The housing is combined with the bottom box **22** from the inside of the box via a screw. It further comprises a box cap **5.** A circuit control board 4 is disposed in the electricity meter case, and can be replaced by the main control unit of the electronic locking and sealing device. A hole corresponding to the upper housing **11** is disposed on the lower housing **16.** The connecting part **3** is received in the opening **111** of the upper housing **11** in the box via the insertion hole of the box cover **21,** and enters a U-shaped groove **17** of a self-test unit, whereby obstructing a light path. At this time, the main control unit obtains a control signal, the lock tongue **12** extends and is received in the hole of the connecting part **3.** Then a reset spring **32** at the bottom of the lower housing is compressed, the top of the connecting part **3** is fixed to the insertion hole of the box cover **21,** and the bottom thereof extends into the housing and is blocked by the lock tongue **12,** which makes impossible to pull the connecting part **3** from the hole, and thus implementing combination of the box cover **21** with the bottom box **22.** The combination makes it difficult to open the box from outside, because it is impossible to touch the hole **31** of the connecting part.

As a command of opening the box is transmitted via the RFID card or wireless control, the lock tongue **12** is detached from the hole **31** of the connecting part, and the connecting part **3** is ejected under the elastic action of the reset spring **32.**

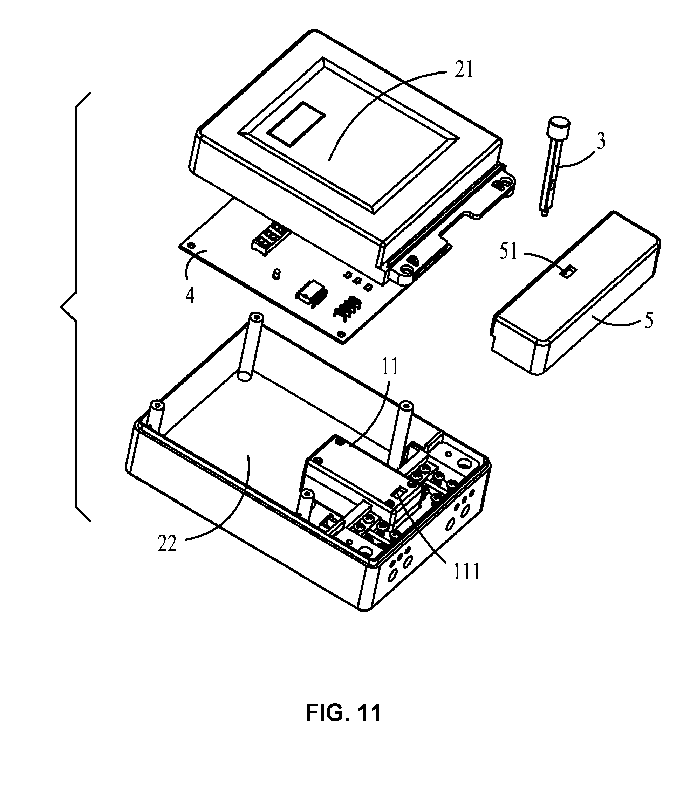

As shown in FIG. **11** and FIG. **12****,** an exploded view and a side cross-sectional view of a case (electricity meter case) with an electronic locking and sealing device of a fourth embodiment of the invention are respectively shown. Difference between this embodiment and the third embodiment is that, the electronic locking and sealing device comprises a cap **5** at an installation position of the bottom box **22,** and a cap hole **51** is disposed on the cap **5,** corresponds to a gap on the box cover **21,** and covers the top of the gap of the box cover **21.** The connecting part **3** extends from the cap hole **51** of the cap **5,** is received in the opening **111** of the upper housing **11** in the box via the gap of the box cover **21,** and enters the U-shaped groove **17** of the self-test unit, and thus obstructing a light path. At this time, the main control unit obtains a control signal, the lock tongue **12** extends and is received in the hole **31** of the connecting part. The reset spring **32** at the bottom of the lower housing **16** is compressed, the top of the connecting part **3** is fixed to the cap hole **51** of the cap, and the bottom thereof is received in the housing and blocked by the lock tongue **12,** which makes impossible to pull the connecting part **3** from the hole, and thus implementing combination of the box cover **21** with the bottom box **22.** The combination makes it difficult to open the box from outside, because it is impossible to touch the hole **31** of the connecting part.

The above-mentioned embodiments are application of the electronic locking and sealing device in the case or the box. Since the main control unit is a key component that implements push-out/take-back of the lock tongue **12,** and receives a command via a RF technique or wirelessly, an external device must be used. The external device can be a fixed device, or a handset or a RF card for the convenience of carrying and mobility.

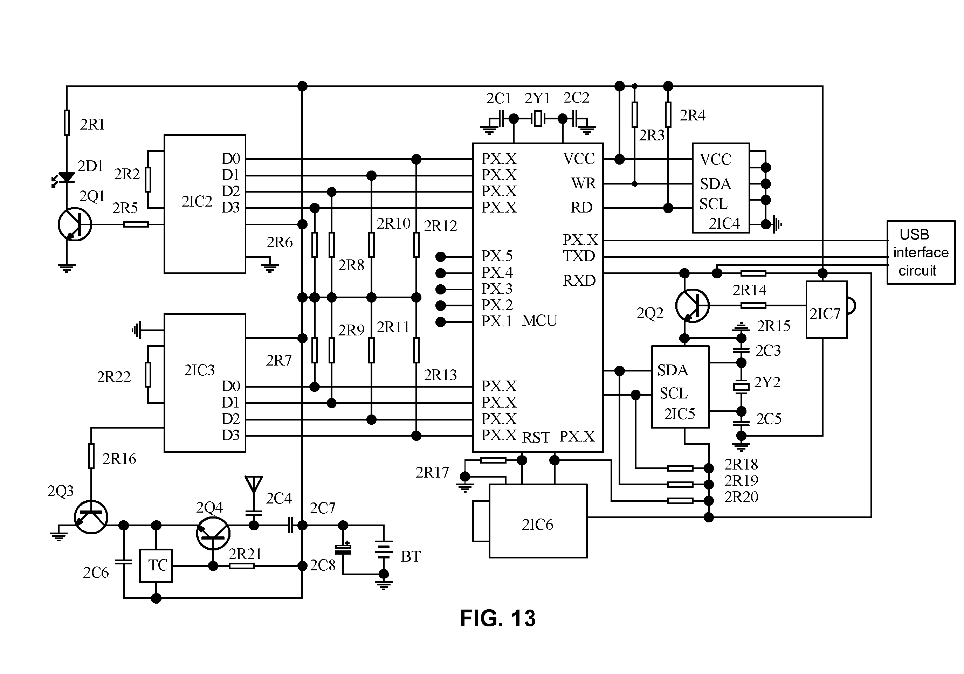

As shown in FIG. **13****,** a circuit diagram of an external control device of an electronic locking and sealing device of the invention is shown. For a RF technique, the external control device is a RF card, and the RF technique will not be described hereinafter. Taking a handset for example, it has a command transmission unit operating to transmit control instructions to the electronic locking and sealing device, namely corresponding to the instruction receiving sub-unit. Therefore there are three different methods to implement this.This embodiment comprises: an infrared reflector 2D1 combined with a corresponding encoder chip 2IC2, and a wireless transmission circuit, comprising a wireless transmitter 2IC3, corresponding components, and an antenna, the circuit can also be used alone, multiple pull-up resistors 2R6-2R13 are disposed between the infrared transmitter 2IC2 and the wireless transmitter 2IC3, and the microprocessor chip MCU; a clock chip 2IC5 operating to provide an external clock for processing of the microprocessor chip MCU, the clock signal operates as an encryption/decryption factor, namely the clock signal is operated as a random number, after being processed by the microprocessor chip MCU, a transmitted control command signal has higher safety; a watchdog chip 2IC6;
a data transmission interface connected to the microprocessor chip MCU, it can be a USB port operating to transmit data to a corresponding receiving device;
an infrared receiver 2IC7 operating to receive a signal containing the data from the data transmission interface of the electronic locking and sealing device; and
a storage chip connected to the microprocessor chip MCU and operating to store data, the data being operation time and frequency of the operating unit.

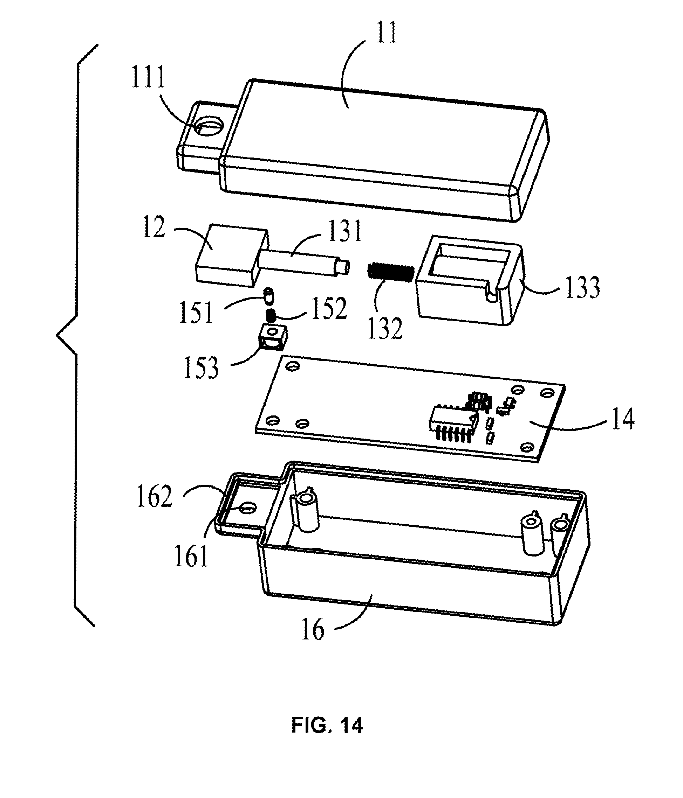

As shown in FIG. **14****,** a schematic view of an electronic locking and sealing device corresponding to a control system of the invention is shown. The electronic locking and sealing device comprises a housing, comprising an upper housing **11,** and a lower housing **16.** It further comprises a lock tongue **12** operating to implement covering and sealing at a predetermined position; an operating unit **13** fixedly connected to the lock tongue **12** and disposed in the housing, and operating to push out or to take back the locking tongue **12** from or in the housing. After the lock tongue **12** is pushed out, its position is above the predetermined position. The operating unit **13** comprises an operating sub-unit, which is an electromagnet or a motor. Taking an electromagnet for example, it comprises an armature **131,** an electromagnetic coil **132,** and a load bearing part **133.** One end of the armature **131** is fixedly connected to the lock tongue **12,** and integrated in the load bearing part **133.** Both ends of the electromagnetic coil **132** are connected to the control unit, whereby controlling operation of the electromagnet.

An extending part **161** is disposed on the lower housing **16,** and a stop hole **162** is disposed on the extending part **161.** It is possible that only one extending part **161** is disposed on the lower housing **16,** or a pair of extending parts **161** is respectively disposed on the upper housing **11** and the lower housing **16,** at the time the stop plate **12** is disposed between the extending parts. As the connecting part extends into the stop hole **162** via the opening **111** of the upper housing **11,** and is combined with corresponding components, the lock tongue **12** is pushed out, whereby covering and sealing the connecting part, which makes it impossible to touch the connecting part via tools, and thus protection thereof is implemented.

The electronic locking and sealing device retracting the lock tongue **12** has a self-locking function, which prevents the lock tongue **12** from being pushed out from or taking back in the housing via tools. This can be implemented by an electromagnetic with a self-holding function, or by a self-locking mechanism **15.** Two concave holes (shown at the bottom of the surface) are disposed on the lock tongue **12,** and respectively correspond to an extending position and a retracting limit position. The self-locking mechanism comprises a first electromagnetic operating part. The first electromagnetic operating part comprises a first electromagnetic coil **152,** a first armature **151,** and a first load bearing part **153.** The first armature **151** extends upon receiving a control instruction, and is received in the concave hole on the lock tongue **12,** whereby implementing the self-locking function.

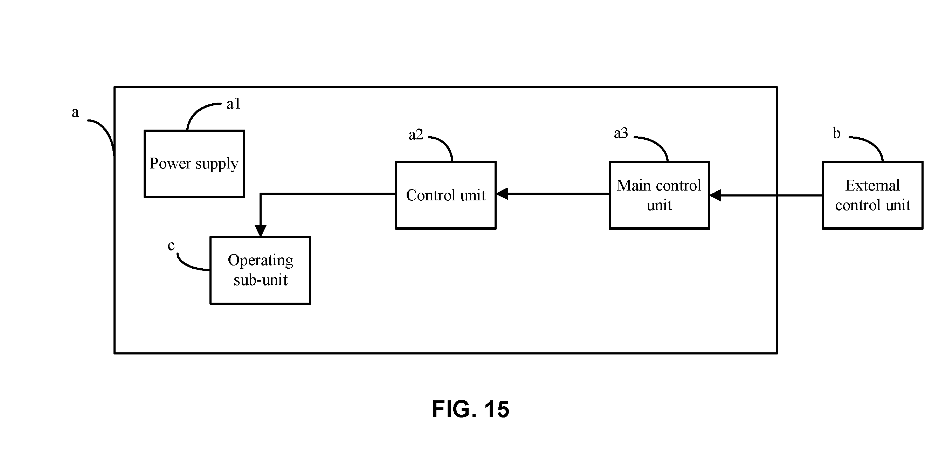

As shown in FIG. **15****,** a block diagram of a control system of a first embodiment of the invention is shown. The control system comprises: a power supply a1 operating to supply power, a control unit a2 connected to an operating sub-unit c, and operating to receive a push-out/take-back control instruction therefrom, and to output a trigger signal driving a lock tongue to operate to said operating sub-unit c, whereby controlling retraction of the operating sub-unit c, a main control unit a3 operating to receive an external control instruction, and to output the push-out/take-back control instruction after processing, and an external control unit b operating to output the external control instruction according to requirement of users. For convenient operation, the external control unit b may be a handset. The power supply a1, the control unit a2, and the main control unit a3 are disposed in the electronic locking and sealing device a, and namely on a circuit board **14** in FIG. **1****.**

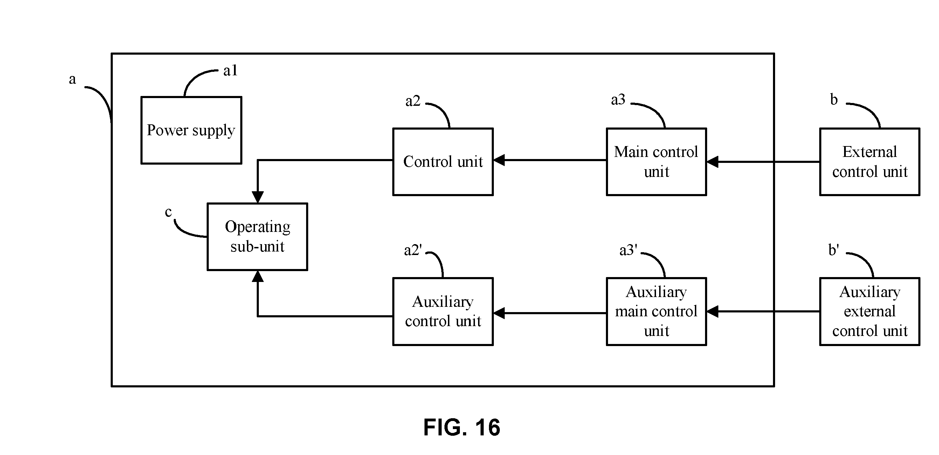

As shown in FIG. **16****,** a block diagram of a control system of a second embodiment of the invention is shown. Compared with the first embodiment, this embodiment adds an auxiliary control system, whereby ensuring the auxiliary control system can implement control functions as the control system of the first embodiment fails and cannot normally control operation of the lock tongue. The auxiliary control system comprises: an auxiliary control unit a2' connected to a control end of the operating sub-unit c, and operating to receive an auxiliary push-out/take-back control instruction, and to output a trigger signal driving the lock tongue to operate to the operating sub-unit c whereby controlling retraction of the operating sub-unit c; an auxiliary main control unit a3' operating to receive an auxiliary external control instruction, and to output the auxiliary push-out/take-back control instruction after processing; and an auxiliary external control unit b' operating to output the auxiliary external control instruction. It should notice that the auxiliary control unit a2' and the auxiliary main control unit a3' are disposed in the electronic locking and sealing device a, and the auxiliary external control unit b' can be integrated with or separated from the external control unit b, and physical combination of data lines implement interaction of corresponding data.

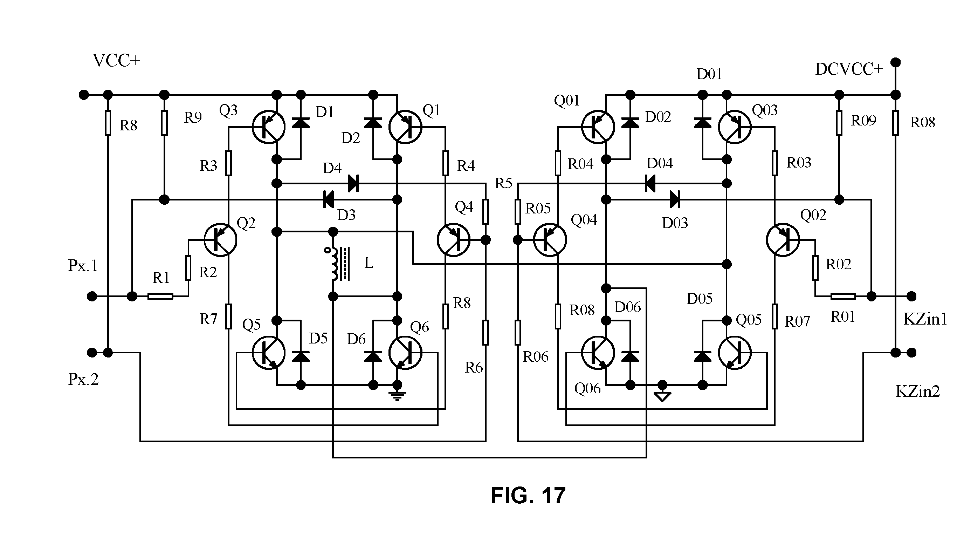

As shown in FIG. **17****,** a circuit diagram of an auxiliary control unit and a control unit in a control system of the invention is shown. The control unit and the auxiliary control unit are symmetrically disposed on a control end of the operating sub-unit. The operating sub-unit is an electromagnet or a motor. The circuit diagram illustrates an electromagnet. PX.1 and PX.2 are output ends for the push-out/take-back control instruction from the main control unit, and Kzin1 and Kzin2 are output ends for the auxiliary push-out/take-back control instruction from the auxiliary main control unit. Herein, since both units are symmetric in structure, structure and operation of the control is explained as an example, and it comprises:
a first signal generation circuit, comprising: a third triode Q3 and a sixth triode Q6 each having an emitting electrode being connected to the control end of the operating sub-unit L, and a second triode Q2 having an emitting electrode and
a collecting electrode being respectively connected to a base electrode of the third triode Q3 and that of the sixth triode Q6, and
a second signal generation circuit, comprising a first triode Q1 and a fifth triode Q5 each having an emitting electrode being connected to the control end of the operating sub-unit L, and a fourth triode Q4 having an emitting electrode and a collecting electrode being respectively connected to a base electrode of the first triode Q1 and that of the fifth triode Q5.

A base electrode of each of the first triode Q1 and the second triode Q2 operates to receive the push-out/take-back control instruction, or the auxiliary push-out/take-back control instruction.

Operation process is that, As PX.1 is low level, and PX.2 is high level, the second triode Q2, the third triode Q3, and the sixth triode Q6 are on, and the fourth triode Q4, the first triode Q1, and the fifth triode Q5 are off, current flowing through the electromagnetic coil or the motor has a first direction, and thus forming a first movement direction for the lock tongue. As PX.1 is high level and PX.2 is high level, the second triode Q2, the third triode Q3, the sixth triode Q6, the fourth triode Q4, the first triode Q1, and the fifth triode Q5 are off, at this time no current flows through the electromagnetic coil or the motor, and thus the lock tongue stops moving. As PX.1 is high level and PX.2 is low level, the second triode Q2, the third triode Q3, and the sixth triode Q6 are off, and the fourth triode Q4, the first triode Q1, and the fifth triode Q5 are on, a direction of current flowing through the electromagnetic coil or the motor is opposite to the first direction, and the lock tongue moves in a reverse direction. As PX.1 and PX.2 are low level, no current flows through the electromagnetic coil or the motor, and thus the lock tongue stops moving.

As shown in FIG. **3****,** a schematic diagram of a main control unit of a control system (as described hereinbefore) is shown, it comprises: an instruction receiving sub-unit operating to receive a control instruction, the control instruction being provided from an external wireless device, which solves safety problem caused by mechanical contact-type control. There are three different methods to implement this: an infrared receiver 1IC1 and a decoder circuit 1IC3 are used, or only one radio receiver 1IC2 is used. Resistors 1 R8 and 1 R1 are used for starting oscillation. If the radio receiver 1IC2 is used, an output signal is a decoded digital signal. To improve safety, the infrared receiver 1IC1 and the radio receiver 1IC2 are used to simultaneously receive the external control instruction, and to transmit the external control instruction to a corresponding instruction processing circuit; multiple pull-up resistors 1 R4-1 R13 are disposed between the infrared receiver 1IC1 and the radio receiver 1IC2, and the instruction processing circuit;
an instruction processing circuit connected to the instruction receiving sub-unit, operating to encrypt verify the external control instruction, and to output a push-out/take-back control instruction after verification is completed, being a microprocessor chip MCU, and operating to process a control instruction. Ports PX.1 and PX.2 of the microprocessor chip MCU output a push-out/take-back control instruction, namely a push-out instruction signal, a take-back instruction signal, or a static instruction signal to the control unit; a clock chip 1IC5 connected to the microprocessor chip MCU, and operates to provide an external clock signal for operation of the microprocessor chip MCU. The clock signal operates as an encryption/decryption factor. After the microprocessor chip MCU receives two types of decoded digital signal via the infrared receiver 1IC1 and the radio receiver 1IC2, the clock signal is operated as a random number, whereby verifying whether it is a legal command. The invention also comprises a watchdog chip 1IC6;
a storage chip 1IC4 connected to the microprocessor chip MCU and operating to store data, the data being operation time and frequency of the control unit; and
a data output circuit connected to the instruction processing circuit, and operating to transmit processed information in the instruction processing circuit to an external control unit, and connected to the microprocessor chip MCU, and operating to transmit various events in the microprocessor chip MCU to an external receiving device. A circuit structure is that, an output end of the microprocessor chip MCU is connected to a base electrode of a triode 1Q1, a collecting electrode of the triode 1Q1 is connected to an infrared emitting diode LED, data are transmitted in a form of infrared signals, and other transmission types can be used, and will not be described hereinafter.

Since each electronic device consumes power, power resource of the invention can use independent devices such as batteries, or city power according to different power utilization environments.

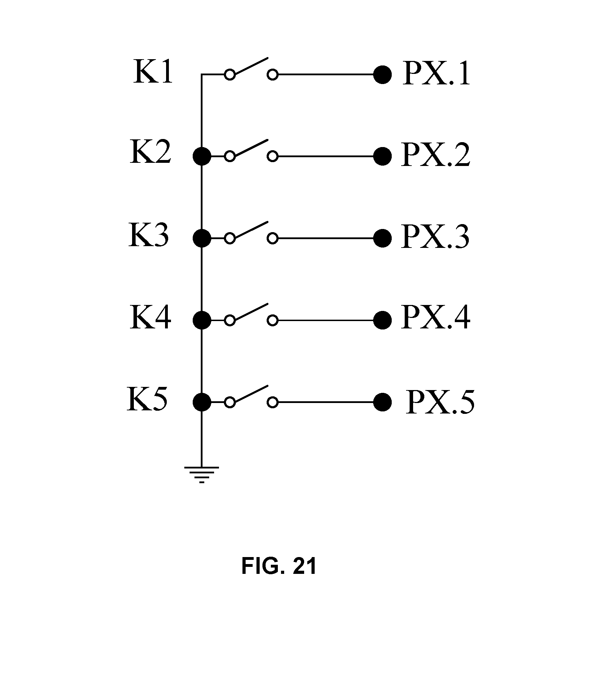

As shown in FIG. **13****,** a schematic diagram of an external control unit of a control system (as described hereinbefore) is shown, the external control unit comprises:
an instruction transmission circuit operating to transmit the external control instruction to the instruction receiving sub-unit, and corresponding to the instruction receiving sub-unit. Therefore there are three different methods to implement the circuit, comprising: an infrared reflector 2D1, a corresponding encoder chip 2IC2, and a wireless transmission circuit, comprising a wireless transmitter 2IC3, corresponding components, and an antenna, the circuit can also be used alone;
a first input interface circuit operating to generate corresponding code values via manual operation, and comprising multiple switching keys (as shown in FIG. 21);
a first processing circuit being a microprocessor chip MCU, and having ports PX.1~PX.5 being connected to the first input interface circuit, and multiple pull-up resistors 2R6-2R13 being disposed between the infrared transmitter 2IC2 and the wireless transmitter 2IC3, and the microprocessor chip MCU; a clock chip 2IC5 operating to provide an external clock for processing of the microprocessor chip MCU, the clock signal operates as an encryption/decryption factor, namely the clock signal is operated as a random number, after being processed by the microprocessor chip MCU, a transmitted control command signal has higher safety; a watchdog chip 2IC6;
a data transmission interface connected to the microprocessor chip MCU, it can be a USB port operating to transmit data to a corresponding receiving device;
an infrared receiver 2IC7 operating to receive a signal containing the data from the data transmission interface of the electronic locking and sealing device; and
a storage chip connected to the microprocessor chip MCU and operating to store data, the data being operation time and frequency of the electronic locking and sealing device.

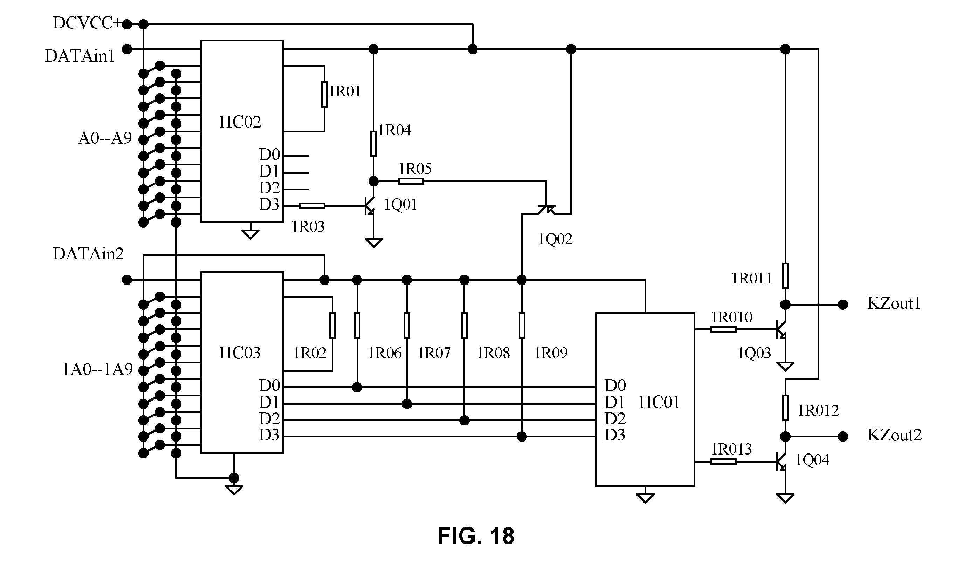

As shown in FIG. **18****,** a circuit diagram of an auxiliary main control unit in a control system of the invention is shown, the auxiliary control unit comprises:
an input decoder circuit operating to receive, to decode, and to check the auxiliary external control instruction, and to output a third output signal after checking is completed.
the input decoder circuit comprising:
   a first decoder chip 1IC02 operating to receive the address code and the auxiliary external control instruction of the auxiliary external control unit, to compare the address code of the auxiliary external control unit with that of itself, and to output a first decoding signal as the address codes are the same;
   a second decoder chip 1IC03 operating to compare the address code of the auxiliary external control unit with that of itself, and to receive the auxiliary external control instruction and to output a third output signal as the address codes are the same; and
   a seventh triode 1Q02 disposed between the power supply and the second decoder chip 1IC03, and operating to receive the first decoding signal, whereby enabling the power supply to supply power to the second decoder chip 1IC03.
   and
a decoding and output circuit, comprising a decoder chip 1IC01 operating to receive and decode the third output signal, and to output the auxiliary push-out/take-back control instruction via the ports Kzout1 and Kzout2.

It should be noted that if address codes A0-A9 of the first coder chip 1IC02 and the second decoder chip 1IC03 are the same as those of the auxiliary external control unit, as data input from the port DATAIN1 are decoded via the first decoder chip 1IC02 and a data end D3 is high level, the eighth triode 1Q11 and the seventh triode 1Q12 are on, and supply power to the second decoder chip 1IC03, meanwhile, a port DATAIN2 inputs a data signal and the second decoder chip 1IC3 and the decoder chip 1IC1 decode it, and output voltage controls on or off of the ninth triode 1Q03 and the thirteenth triode 1Q04, whereby controlling content of the auxiliary push-out/take-back control.

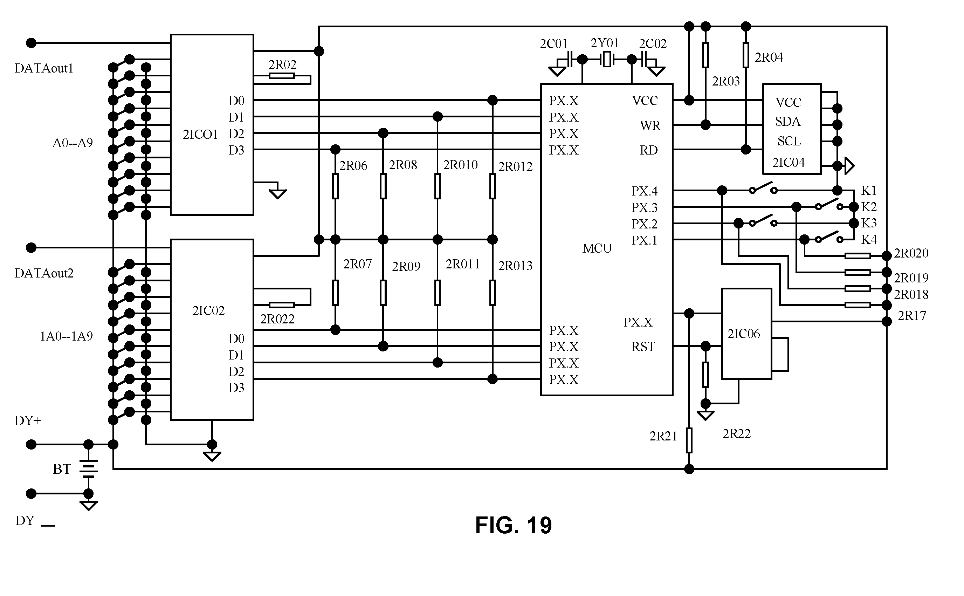

As shown in FIG. **19****,** a circuit diagram of an auxiliary external control unit in a control system of the invention is shown. The auxiliary external control unit comprises: a second input interface circuit operating to generate a corresponding code value via manual operation, and comprising multiple switching keys K1-K4; a second processing circuit being a microprocessor chip MCU, and operating to obtain the code value and to transform it into a second output signal according to a preset program, and a coding and output circuit, comprising a third decoder chip 2IC01 and a fourth decoder chip 2IC02, and operating to receive the second output signal, to encode it, and to output the auxiliary external control instruction and an address code signal, multiple pull-up resistors 2R06-2R013 being disposed between the third decoder chip 2IC01 and the fourth decoder chip 2IC02; a watchdog chip 2IC06; and a storage chip 2IC04 connected to the microprocessor chip MCU, and operating to save data, the data being operation time and frequency of the auxiliary control system. During use, data signals DATAout1 and DATAout2, address codes A0-A9 and 1A0-1A9 output via the auxiliary external control unit are respectively connected to data signal ports DATAin1 and DATAint2, and address codes A0-A9 and 1A0-1A9 of the auxiliary main controller, and the connection is mechanical.

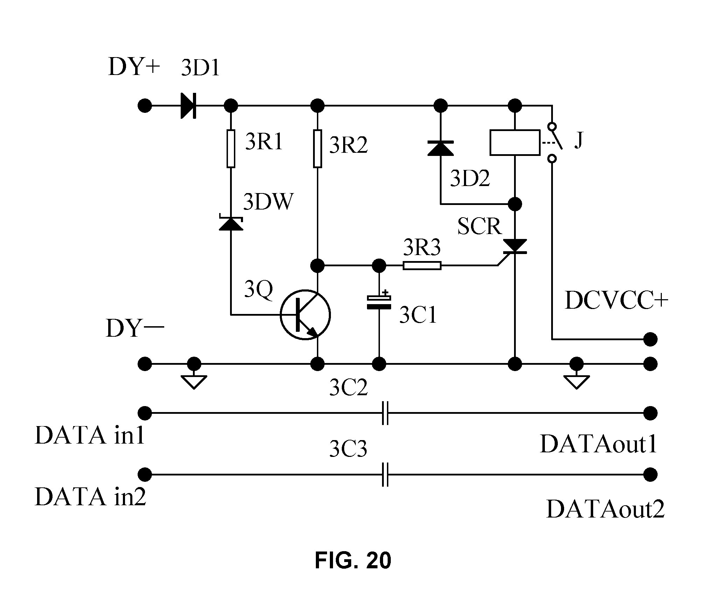

As shown in FIG. **20****,** a schematic view of a protection circuit in a control system of the invention is shown. Since the auxiliary external control unit is physically combined with the auxiliary control unit, a physical entity interface exists on the electronic locking and sealing device. To prevent people from maliciously reverse-connecting the power supply, or from corrupting the control system in the electronic locking and sealing device with high voltage. The protection circuit comprises a power supply access circuit and a data access circuit. The power supply access circuit comprises: a rectifying diode 3D1 operating to prevent reverse connection of a DC power supply and connection to an AC power, and a voltage stabilizing diode 3DW, a triode 3Q, a silicon-controlled rectifier SCR, and a relay J sequentially connected whereby preventing DC overvoltage. The data access circuit comprises a high voltage resistance and small-volume capacitors 3C2 and 3C3 disposed on a data line.

Operation principle of the protection circuit is: the protection circuit makes use of forward turn-on of the diode 3D1, prevents reverse connection of the power supply and thus circuit breakdown in the locking and sealing device, and prevents input of AC voltage whereby implementing rectifying. As AC voltage is input, it is rectified via the diode 3D1. As DC voltage is comparatively high, the voltage stabilizing diode 3DW is on, the triode 3Q is on, a collecting electrode of the triode 3Q is low potential, the silicon-controlled rectifier SCR is off, the relay J is not closed, input voltage does not enter the locking and sealing device and cannot corrupt a circuit thereof. The data input ports DATAin1 and DATAin2 prevent input of AC and DC voltage and thus corruption of an internal circuit via the high voltage resistance and small-volume capacitors 3C2 and 3C3.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the true spirit and scope of the invention.

## Claims

1. An electronic locking and sealing device, comprising a housing, **characterized in that**
it further comprises
a lock tongue,
an operating unit disposed in said housing and fixedly connected to said lock tongue, and operating to push out or to take back said locking tongue from or in said housing;
a main control unit connected to said operating unit, and operating to receive an external control instruction whereby automatically controlling said operating unit; and
a connecting part having a hole disposed at the center thereof and corresponding to said lock tongue.

2. A case with an electronic locking and sealing device, comprising a bottom case; and
a cover having an insertion hole;
**characterized in that**
it further comprises an electronic locking and sealing device disposed in said bottom case and comprising
a housing;
a lock tongue,
an operating unit disposed in said housing and fixedly connected to said lock tongue, and operating to push out or to take back said locking tongue from or to said housing;
a main control unit connected to said operating unit, and operating to receive an external control instruction whereby automatically controlling said operating unit; and
a connecting part inserted into said insertion hole, the top of said connecting part being fixed on said insertion hole, and a hole being disposed at the center of said connecting part, and corresponding to said lock tongue.

3. The electronic locking and sealing device and the case of claim 1 or 2, further comprising a self-test unit operating to detect whether said connecting part is received in said housing, and to transmitting an external control instruction to said main control unit whereby pushing out said operating unit as said connecting part is received in said housing.

4. The electronic locking and sealing device and the case of claim 3, **characterized in that**
said operating unit comprises a power output mechanism having an output end being connected to said lock tongue; and
said main control unit is connected to a control part of said power output mechanism.

5. The electronic locking and sealing device and the case of claim 4, **characterized in that**
said power output mechanism comprises a motor, and a multi-stage gear reduction part connected to an output shaft thereof; and
said multiple-stage gear reduction part is connected to said operating unit via a connecting shaft.

6. The electronic locking and sealing device and the case of claim 4, **characterized in that**
said power output mechanism comprises an electromagnetic operating part;
said electromagnetic operating part comprises an electromagnetic coil and an armature;
one end of said armature is connected to said operating unit; and a reset spring is fit on said armature.

7. The electronic locking and sealing device and the case of claim 4, **characterized in that**
said power output mechanism comprises a motor, and a multiple-stage gear reduction part connected to an output shaft thereof; and
one side of said operating unit is in the shape of a rack, and engaged with an output stage gear of said multiple-stage gear reduction part.

8. The electronic locking and sealing device and the case of claims 1-7, **characterized in that**
said main control unit comprises
an instruction receiving sub-unit operating to receive an external control instruction;
an instruction processing sub-unit connected to said instruction receiving sub-unit, and operating to process said external control instruction, and to output a push-out instruction signal, a take-back instruction signal, or a static instruction signal; and
a data output sub-unit connected to said instruction processing sub-unit, and operating to transmit processed information in said instruction processing sub-unit to an external receiving device.

9. The electronic locking and sealing device and the case of claim 8, **characterized in that**
said instruction receiving sub-unit is a RFID card reader circuit.

10. The electronic locking and sealing device and the case of claim 8, **characterized in that**
said self-test unit comprises a U-shaped groove;
said U-shaped groove comprises a light receiving end, and a light emitting end, a light path being formed therebetween; and
a control signal is generated during switching between closing and opening of said light path.

11. The electronic locking and sealing device and the case of claim 8, **characterized in that**
said self-test unit comprises a pressure sensor disposed at the bottom of said housing and corresponding to the top of said connecting part.

12. The electronic locking and sealing device and the case of claim 8, **characterized in that**
said instruction processing sub-unit is a processor;
said processor is connected to a clock chip; and
said clock chip operates to provide external clock data for each processing operation of said processor.

13. The electronic locking and sealing device and the case of claim 12, further comprising a storage chip connected to said processor, and operating to stores operation time and frequency of said operating unit.

14. A control system for the electronic locking and sealing device and the case of preceding claims, comprising
a power supply operating to supply power;
a control unit operating to receive a push-out/take-back control instruction, and to output a trigger signal driving a lock tongue to operate;
a main control unit operating to receive an external control instruction, and to output said push-out/take-back control instruction to said control unit; and
an external control unit operating to output said external control instruction.

15. The control system of claim 14, **characterized in that** said main control unit comprises
an instruction receiving sub-unit operating to receive said external control instruction;
an instruction processing circuit connected to said instruction receiving sub-unit, and operating to decrypt and to verify said external control instruction, and to output said push-out/take-back control instruction; and
a data output circuit connected to said instruction processing circuit, and operating to transmit processed data in said instruction processing circuit to said external control unit.

16. The control system of claim 15, **characterized in that** said external control unit comprises:
an instruction transmission circuit operating to transmit said external control instruction to said instruction receiving sub-unit;
a first input interface circuit operating to generate a corresponding code value via manual operation;
a first processing circuit connected to said first input interface circuit, and operating to generate an encryption/decryption factor via a clock chip, and to generate a first control command to said instruction transmission circuit via encryption; and
a data transmission circuit connected to said first processing circuit, and operating to transmit data thereto.

17. The control system of claim 14 or 16, further comprising an auxiliary control system, comprising
an auxiliary control unit operating to receive an auxiliary push-out/take-back control instruction, and to output a trigger signal driving said lock tongue to operate;
an auxiliary main control unit operating to receive an auxiliary external control instruction, and to output said auxiliary push-out/take-back control instruction after processing; and
an auxiliary external control unit operating to output said auxiliary external control instruction.

18. The control system of claim 17, **characterized in that**
said control unit and said auxiliary control unit are symmetrically disposed on a control end of an operating sub-unit; and
said operating sub-unit is a electromagnet or a motor.

19. The control system of claim 18, **characterized in that** said control unit and said auxiliary control unit each comprises:
a first signal generation circuit, comprising: a third triode and a sixth triode each having an emitting electrode being connected to said control end of said operating sub-unit, and a second triode having an emitting electrode and a collecting electrode being respectively connected to a base electrode of said third triode and that of said sixth triode;
a second signal generation circuit, comprising a first triode and a fifth triode each having an emitting electrode being connected to said control end of said operating sub-unit, and a fourth triode having an emitting electrode and a collecting electrode being respectively connected to a base electrode of said first triode and that of said fifth triode; and
a base electrode of each of said first triode and said second triode operates to receive said push-out/take-back control instruction, or said auxiliary push-out/take-back control instruction.

20. The control system of claim 17, **characterized in that** said auxiliary external control unit is an independent control device, or on a same control device as said external control unit; and said auxiliary external control unit comprises:
a second input interface circuit operating to generate a corresponding code value via manual operation;
a second processing circuit operating to obtain said code value and to transform it into a second output signal according to a preset program; and
a coding and output circuit operating to receive said second output signal, to encode it, and to output said auxiliary external control instruction and an address code signal.

21. The control system of claim 20, **characterized in that** said auxiliary external control unit further comprises an auxiliary power supply with an output end.

22. The control system of claim 17, **characterized in that** said auxiliary control unit comprises:
an input decoder circuit operating to receive, to decode, and to check said auxiliary external control instruction and said address code signal, and to output a third output signal after checking is completed; and
a decoding and output circuit operating to receive and decode said third output signal, and to output said auxiliary push-out/take-back control instruction.

23. The control system of claim 22, **characterized in that** said input decoder circuit comprises:
a first decoder chip operating to receive said address code and said auxiliary external control instruction of said auxiliary external control unit, to compare said address code of said auxiliary external control unit with that of itself, and to output a first decoding signal as the address codes are the same;
a second decoder chip operating to compare said address code of said auxiliary external control unit with that of itself, and to receive said auxiliary external control instruction and to output a third output signal as the address codes are the same; and
a seventh triode disposed between said power supply and said second decoder chip, and operating to receive said first decoding signal, whereby enabling said power supply to supply power to said second decoder chip.

24. The control system of claim 17, further comprising a protection circuit disposed on a receiving end of said auxiliary control unit, and operating to protect reverse connection of said power supply, or high voltage corruption.

25. The control system of claim 24, **characterized in that**
said protection circuit comprises a power supply access circuit, and a data access circuit;
said power supply access circuit comprises a rectifying diode operating to prevent reverse connection of a DC power supply and connection to an AC power, and a voltage stabilizing diode, a triode, a silicon-controlled rectifier, and a relay sequentially connected whereby preventing DC overvoltage; and
said data access circuit comprises a high voltage resistance and small-volume capacitor disposed on a data line.
